# EUROPÄISCHE PATENTANMELDUNG

(11) **EP 4 788 074 A1**
(43) Veröffentlichungstag der Anmeldung: **05.08.2026**
(21) Anmeldenummer: 25213079.4
(22) Anmeldetag: 03.11.2025
(51) Int. Cl.: H05K 7/20

(54) **SYSTEM, UMFASSEND EINEN DATENLOGGER**

(30) Priorität: 29.01.2025 DE 102025103218
(71) Anmelder: IPETRONIK GmbH & Co. KG, 76532 Baden-Baden (DE)
(72) Erfinder: Dohr, Yves, 76137 Karlsruhe (DE)
(74) Vertreter: Meissner Bolte Partnerschaft mbB

(57) **Zusammenfassung**

System, umfassend einen Datenlogger (10) zur Erfassung von Daten eines Fahrzeuges, eine Kühleinrichtung (16) zur Kühlung, insbesondere des Datenloggers (10) und/oder eines Innenraumes des Fahrzeuges, sowie eine Steuereinrichtung, die konfiguriert ist, eine Kühlung in Abhängigkeit von einer durch den Datenlogger (10) emittierten Abwärme durchzuführen.

## Beschreibung

Die Erfindung betrifft ein System, umfassend einen Datenlogger zur Erfassung von Daten eines Fahrzeuges und eine Kühleinrichtung zur Kühlung. Weiterhin betrifft die Erfindung ein Verfahren zum Herrichten eines Fahrzeuges sowie ein Verfahren zum Betreiben eines Datenloggers zur Erfassung von Daten eines Fahrzeuges.

Aus dem Stand der Technik sind Datenlogger für Kraftfahrzeuge (DAQ-Systeme, wobei DAQ für "Data Aquisition" steht) grundsätzlich bekannt. Diese können beispielsweise in einem Innenraum des Fahrzeugs, beispielsweise im Kofferraum, angeordnet werden und insbesondere Daten während des Betriebs des Fahrzeugs messen und beispielsweise zu Analysezwecken aufzeichnen. Ein solcher Datenlogger kann Messdaten mit dem Ziel sammeln, das Fahrzeug zu charakterisieren, zu überwachen und/oder zu steuern. Ein entsprechender Datenlogger (DAQ-System) kann umfassen: Mindestens einen Sensor, mindestens einen Messverstärker, mindestens einen Analog-DigitalWandler und/oder mindestens eine Recheneinheit mit einer DAQ-Software für die Protokollierung und Analyse von Messsignalen.

Ein Datenlogger (DAQ-System) kann verschiedene physikalische Größen messen, wie z. B. eine Temperatur, eine Spannung, einen Strom, einen Druck, eine Vibration und/oder eine Drehzahl. Die erfassten analogen Signale können in digitale Daten umgewandelt werden und beispielsweise und in einem elektronischen Speicher gespeichert werden.

Die obigen Merkmale kann auch der erfindungsgemäße Datenlogger (bzw. DAQ-System) umfassen.

Als problematisch wird angesehen, dass bekannte Systeme gerade bei extremen äußeren Bedingungen hinsichtlich einer Präzision bei der Aufnahme und ggf. Weiterverarbeitung der Daten, verbesserungsfähig sind.

Es ist insbesondere Aufgabe der Erfindung, ein System vorzuschlagen, mit dem auf möglichst einfache Art und Weise eine Performance des Datenlog-Vorgangs verbessert werden kann. Es ist weiterhin Aufgabe der Erfindung, ein entsprechendes Verfahren aufzuzeigen.

Die oben genannte Aufgabe wird gemäß einem ersten Aspekt insbesondere durch ein System, umfassend einen Datenlogger (DAQ-System) zur Erfassung (Aufnahme) von Daten eines Fahrzeuges, eine Kühleinrichtung zur Kühlung, insbesondere des Datenloggers und/oder eines Innenraumes des Fahrzeuges (vorzugsweise Kraftfahrzeuges, insbesondere Pkw und/oder Lkw), sowie eine Steuereinrichtung, die konfiguriert ist, eine Kühlung in Abhängigkeit von einer durch den Datenlogger emittierten Abwärme durchzuführen, gelöst.

Ein Gedanke des obigen ersten Aspektes liegt darin, dass eine Kühlung in Abhängigkeit einer durch den Datenlogger emittierten Abwärme durchgeführt wird. Dadurch kann beispielsweise ein effektiver Wärmeeintrag durch das Gesamtsystem reduziert werden. In diesem Zusammenhang wurde insbesondere erkannt, dass unter hohen thermischen Umgebungsbedingungen ein DAQ-System (Datenlogger) teilweise lediglich eingeschränkt oder nicht betrieben werden kann. Insbesondere wurde erkannt, dass die Abwärme, beispielsweise von High-Performance-DAQ-Systemen, und deren Einfluss auf ein Messergebnis nicht (mehr) vernachlässigbar ist. Erfindungsgemäß kann diese Beeinflussung nun zumindest reduziert werden. Insgesamt kann dadurch die Performance beim Loggen der Daten verbessert werden.

Der Datenlogger weist vorzugsweise ein Gehäuse auf. Der Datenlogger kann konfiguriert sein, in einem Fahrzeug, insbesondere in einer Fahrzeugkabine und/oder einem Kofferraum des Fahrzeuges (Kraftfahrzeuges) angeordnet zu werden. Bei dem Datenlogger kann es sich um eine mobile und/oder separate Einheit handeln, die nicht in dem Fahrzeug integriert ist, sondern bei Bedarf dort untergebracht werden kann.

Das System kann mindestens einen Sensor und/oder mindestens eine Berechnungseinheit zur Erfassung der Abwärme des Datenloggers umfassen.

Grundsätzlich kann die Abwärme sensorisch und/oder durch Berechnung festgestellt werden. Beispielsweise kann die Temperatur in und/oder an einem Luftauslass (einer Kühlluft bzw. einer Gebläseanordnung am und/oder im Datenlogger) gemessen werden und daraus die Abwärme bestimmt werden. Alternativ oder zusätzlich kann die Abwärme auch rechnerisch bestimmt werden, beispielsweise auf Grundlage einer verbrauchten elektrischen Leistung des Datenloggers.

Eine Kühlung in Abhängigkeit einer durch den Datenlogger emittierten Abwärme impliziert insbesondere, dass die Abwärme entsprechend bestimmt oder zumindest abgeschätzt wird und die entsprechend bestimmte/abgeschätzte Abwärme als Input für die Steuereinrichtung herangezogen wird, die basierend auf diesem Input eine entsprechende Kühlung durchführt.

Ein Prozessor und/oder ein elektronisches Speichermedium und/oder eine Input-Einrichtung und/oder eine Output-Einrichtung kann/können Bestandteil der Steuereinrichtung sein und/oder dieser zugeordnet sein. Komponenten der Steuereinrichtung können auch extern bereitgestellt werden (beispielsweise auf einem Server und/oder einer mobilen Recheneinheit, z. B Smartphone). Eine derartige "externe" Bereitstellung bildet jedoch vorzugsweise immer noch einen Bestandteil des Systems.

Die Kühleinrichtung kann konfiguriert sein zur (unmittelbaren) Kühlung des Datenloggers, beispielsweise dadurch, dass eine am Datenlogger vorbei und/oder durch diesen hindurch strömende Kühlluft unmittelbar (über einen Wärmetauscher) gekühlt wird. Alternativ oder zusätzlich kann auch eine (allgemeine) Kühlung des Innenraumes des Fahrzeuges erfolgen, beispielsweise beabstandet von dem Datenlogger.

Die Steuereinrichtung ist vorzugsweise konfiguriert, eine Kühlung in Abhängigkeit von einer durch den Datenlogger emittierten Abwärme zu regeln.

Gemäß einem zweiten Aspekt wird die oben genannte Aufgabe insbesondere gelöst durch ein System (insbesondere gemäß dem obigen ersten Aspekt), umfassend einen Datenlogger zur Erfassung von Daten eines Fahrzeuges (insbesondere Kraftfahrzeuges, vorzugsweise Pkw und/oder Lkw), sowie eine Kühleinrichtung zur Kühlung des Datenloggers, wobei ein Wärmetauscher der Kühleinrichtung an und/oder auf und/oder in dem Datenlogger, insbesondere einem Gehäuse desselben, angeordnet ist.

Ein Gedanke des zweiten Aspektes liegt darin, dass ein Wärmetauscher einer Kühleinrichtung an und/oder auf und/oder in dem Datenlogger angeordnet wird. Insbesondere können Wärmetauscher und Datenlogger eine Baueinheit bilden. Beispielsweise kann der Wärmetauscher unmittelbar auf einem Gehäuse des Datenloggers befestigt sein und/oder (zumindest teilweise) in dem Datenlogger bzw. ein Gehäuse desselben integriert sein.

Der Wärmetauscher ist vorzugsweise ein Luft-Kühlfluid-Wärmetauscher. Das Kühlfluid kann beispielsweise Wasser umfassen (zu zumindest 80 Vol.-% oder 90 Vol.-%). Vorzugsweise kann Kälte vom Kühlfluid unter Unterstützung eines Gebläses abgeführt werden (bzw. Wärme entsprechend zugeführt werden).

Die obige Aufgabe wird weiterhin gemäß einem dritten Aspekt (der vorzugsweise mit dem ersten und/oder zweiten Aspekt kombinierbar ist) insbesondere gelöst durch ein System, umfassend einen Datenlogger zur Erfassung von Daten eines Fahrzeuges (insbesondere eines Kraftfahrzeuges, vorzugsweise Pkw und/oder Lkw) sowie ein Kühleinrichtung zur Kühlung des Datenloggers, wobei die Kühleinrichtung einen Kompressor umfasst, der konfiguriert ist, außen am Fahrzeug befestigt zu werden.

Ein Gedanke des dritten Aspektes liegt darin, dass zur Kühlung insbesondere des Datenloggers und/oder des Innenraumes des Kraftfahrzeuges, ein Kompressor vorgesehen ist, der außen am Fahrzeug angebracht ist. Dadurch kann auf einfache Art und Weise eine entsprechende Kühlung vorgesehen werden, insbesondere um Abwärme des Datenloggers zumindest teilweise auszugleichen.

Vorzugsweise ist die Steuereinrichtung konfiguriert, die Kühlung so durchzuführen, dass die Abwärme des Datenloggers zumindest teilweise, insbesondere zumindest im Wesentlichen vollständig, kompensiert wird. Vorzugsweise werden mindestens 50 % (d.h. heißt, wenn z. B. 300 W Abwärme vom Datenlogger erzeugt werden, sollen mindestens 150 W Wärme von der Kühleinrichtung nach außen abgeführt werden) und höchstens 150 %, weiter vorzugsweise mindestens 80 % und höchstens 120 %, noch weiter vorzugsweise mindestens 95 % und höchstens 105 % der Abwärme des Datenloggers kompensiert. Ggf. wird (mindestens oder genau) 100 % der Abwärme des Datenloggers kompensiert.

Ein allgemeiner Vorteil einer Kühlung in Abhängigkeit der vom Datenlogger emittierten Wärme, insbesondere einer Kompensation der Abwärme, liegt darin, dass die Abwärme, insbesondere von High-Performance-DAQ-Systemen, und deren Einfluss auf die Messergebnisse weniger gravierend ist bzw. ggf. vernachlässigbar ist.

Gemäß dem ersten, zweiten und/oder dritten Aspekt können auf vergleichsweise einfache Art und Weise vergleichsweise hohe thermische Umgebungsbedingungen toleriert werden, wobei der Datenlogger (bzw. das DAQ-System) weiterhin (uneingeschränkt) betrieben werden kann.

Generell wird eine aktive, universal-einsetzbare Kühlung für den Datenlogger (das DAQ-System) vorgeschlagen.

Bei einem bevorzugten Regelungskonzept (Q_dot = 0) wird vorgeschlagen insbesondere eine Regelung der Kühlleistung der Kühleinrichtung, so durchzuführen, dass eine Abwärme des Datenloggers (DAQ-Systems) innerhalb einer Systemgrenze egalisiert wird.

Insbesondere kann der Datenlogger auch bei Temperaturen von bis zu oder über 80 °C betrieben werden (was beispielsweise bei 40 °C Außentemperatur und Sonnenschein in einem Kofferraum erreicht wird).

Vorzugsweise ist der Wärmetauscher unmittelbar auf dem Gehäuse des Datenloggers angeordnet. Dadurch kann auf einfache Art und Weise Wärme abgeführt werden.

Die Kühleinrichtung kann alternativ oder zusätzlich einen Fluidkreislauf umfassen, beispielsweise um einen Kühlkreislauf zwischen Kompressor und Wärmetauscher zu realisieren.

Der Kompressor kann konfiguriert seine, auf einer Anhängerkupplung montiert zu werden. Alternativ oder zusätzlich kann der Kompressor konfiguriert sein, auf einem Dachträger montiert zu werden.

Weiter alternativ oder zusätzlich kann der Kompressor konfiguriert sein, auf einer, insbesondere glatten, Oberfläche montiert zu werden. Dazu kann der Kompressor (bzw. eine entsprechende Halterung und/oder ein Gehäuse des Kompressors) vorzugsweise mindestens einen Saugnapf aufweisen, insbesondere eine Mehrzahl von Saugnäpfen.

Konkret kann das System eine Fluidleitung umfassen, die konfiguriert ist, durch den Spalt einer geschlossenen Fahrzeugtür, insbesondere Kofferraumtür, geführt zu werden.

Die oben genannte Aufgabe wird weiterhin insbesondere gelöst durch das obige System, umfassend das Fahrzeug.

Insoweit weiter oben Konfigurationen des oben beschriebenen Systems erläutert werden, und zwar in Bezug auf das Fahrzeug, können die Konfigurationen (wenn das Fahrzeug Bestandteil des Systems ist) konkret realisiert sein. Beispielsweise kann der Kompressor konkret auf der Anhängerkupplung montiert sein und/oder der Datenlogger kann konkret in dem Fahrzeug aufgenommen werden.

Die oben genannte Aufgabe wird weiterhin insbesondere gelöst durch ein Verfahren zum Herrichten eines Fahrzeuges, insbesondere eines obigen Systems, vorzugsweise eines obigen Systems umfassend das Fahrzeug, wobei ein Datenlogger zur Erfassung von Daten des Fahrzeuges, sowie eine Kühleinrichtung zur Kühlung des Datenloggers, bereitgestellt wird, wobei ein Wärmetauscher der Kühleinrichtung an und/oder auf und/oder in dem Datenlogger, insbesondere einem Gehäuse desselben, angeordnet ist oder wird und/oder wobei die Kühleinrichtung einen Kompressor umfasst, der außen am Fahrzeug befestigt wird. Weiterbildungen des Verfahrens können Merkmale umfassen, die sich aus der obigen Beschreibung des jeweiligen Systems ergeben, insbesondere soweit es die Anordnung bzw. Herrichtung des Systems betrifft. Beispielsweise kann ein Verfahrensschritt durchgeführt werden, wonach der Kompressor auf einer Anhängerkupplung montiert wird und/oder ein Verfahrensschritt durchgeführt werden, bei dem ein Datenlogger in dem Auto untergebracht wird.

Die oben genannte Aufgabe wird weiterhin insbesondere gelöst durch ein Verfahren zum Betreiben eines Datenloggers zur Erfassung von Daten eines Fahrzeuges, insbesondere unter Verwendung des obigen Systems und/oder unter Verwendung des im vorigen Absatz erläuterten Verfahrens, wobei eine Kühlung, insbesondere des Datenloggers und/oder des Innenraums des Fahrzeugs, in Abhängigkeit von einer durch den Datenlogger emittierten Abwärme durchgeführt wird. Das Verfahren zum Betreiben des Datenloggers kann weitere Schritte umfassen, die sich aus der obigen Beschreibung des Systems ergeben, insbesondere insoweit es das Betreiben des Datenloggers betrifft und/oder die Kühlung bzw. Steuerung derselben. Beispielsweise kann eine Kühlung konkret so durchgeführt werden, dass die Abwärme des Datenloggers zumindest im Wesentlichen kompensiert wird.

Weitere Ausführungsformen ergeben sich aus den Unteransprüchen.

Nachfolgend wird die Erfindung auch hinsichtlich weiterer Merkmale und Vorteile anhand von Ausführungsbeispielen beschrieben, die anhand der Abbildungen näher erläutert werden.

Hierbei zeigen:
- Fig. 1: eine schematische Darstellung eines Systems, umfassend einen Datenlogger sowie eine Kühleinrichtung; und
- Fig. 2: eine schematische Darstellung eines Systems, umfassend ein Fahrzeug, einen Datenlogger und eine Kühleinrichtung.

In der nachfolgenden Beschreibung werden für gleiche und gleich wirkende Teile dieselben Bezugsziffern verwendet.

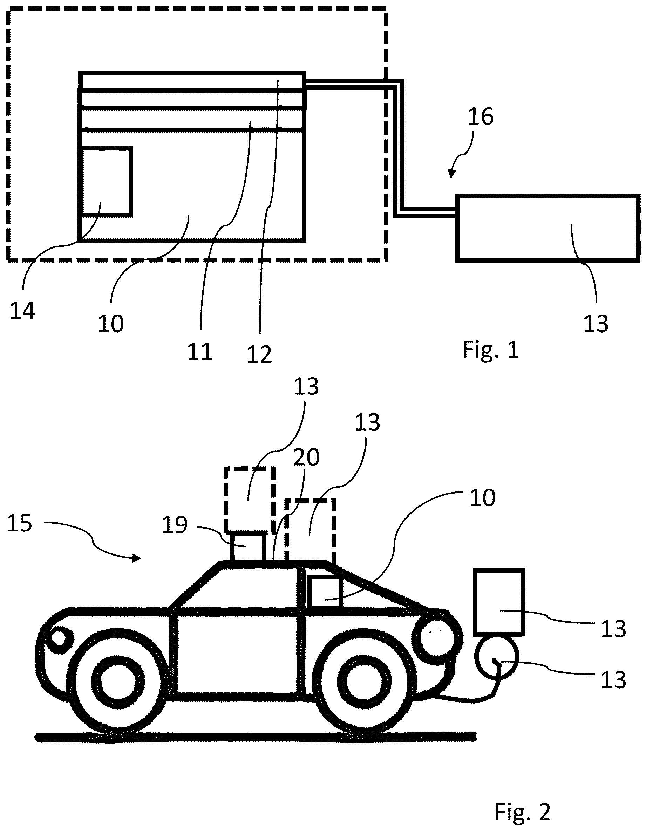

Fig. 1 zeigt eine schematische Darstellung eines Datenloggers sowie einer Kühleinrichtung. Auf dem Datenlogger 10 (bzw. einem Gehäuse desselben) ist eine Luftkanalstruktur 11 angeordnet. Oberhalb der Luftkanalstruktur 11 ist wiederum ein Wärmetauscher 12 vorgesehen. Der Wärmetauscher 12 steht in Fluidverbindung mit einem (außerhalb des hier nicht gezeigten Fahrzeugs) vorgesehenen Kompressor 13 der Kühlreinrichtung 16. Weiterhin weist der Datenlogger eine Steuereinheit 14 auf, die konfiguriert ist, die Kühlung in Abhängigkeit von der Abwärme des Datenloggers zu steuern, insbesondere zu regeln.

Fig. 2 zeigt ein Kraftfahrzeug 15, umfassend den Datenlogger 10 sowie die Kühleinrichtung 16. Der Kompressor 13 der Kühleinrichtung 16 ist hier beispielsweise auf einer Anhängerkupplung 18 angeordnet. Alternativ oder zusätzlich kann der und/oder ein weiterer Kompressor auf einem Dachgepäckträger 19 angeordnet sein und/oder auf einer glatten Oberfläche 20 des Kraftfahrzeuges, beispielsweise mithilfe mindestens eines Saugnapfes (nicht in den Figuren zu sehen).

An dieser Stelle sei darauf hingewiesen, dass alle oben beschriebenen Teile jeweils für sich - auch ohne im jeweiligen Zusammenhang zusätzlich beschriebene Merkmale, selbst wenn diese nicht explizit als optionale Merkmale im jeweiligen Zusammenhang individuell kenntlich gemacht worden sind, z. B. durch Verwendung von: insbesondere, vorzugsweise, beispielsweise, z. B., ggf. runden Klammern etc. - oder in Kombination oder jeglicher Unterkombination als eigenständige Ausgestaltungen bzw. Weiterbildungen der Erfindung, wie sie insbesondere in der Beschreibungseinleitung sowie den Ansprüchen definiert ist, anzusehen sind. Abweichungen hiervon sind möglich. Konkret sei darauf hingewiesen, dass das Wort insbesondere oder runde Klammern, keine im jeweiligen Kontext zwingende Merkmale kennzeichnen.

### Bezugszeichen

- 10: Datenlogger
- 11: Luftkanalstruktur
- 12: Wärmetauscher
- 13: Kompressor
- 14: Steuereinheit
- 15: Kraftfahrzeug
- 16: Kühleinrichtung
- 17: (Arbeits-)Tisch
- 18: Anhängerkupplung
- 19: Dachgepäckträger
- 20: glatte Oberfläche

## Patentansprüche

1. System, umfassend einen Datenlogger (10) zur Erfassung von Daten eines Fahrzeuges, eine Kühleinrichtung (16) zur Kühlung, insbesondere des Datenlogger (10) und/oder eines Innenraumes des Fahrzeuges, sowie eine Steuereinrichtung, die konfiguriert ist, eine Kühlung in Abhängigkeit von einer durch den Datenlogger (10) emittierten Abwärme durchzuführen.

2. System, insbesondere nach Anspruch 1, umfassend einen Datenlogger (10) zur Erfassung von Daten eines Fahrzeuges, sowie eine Kühleinrichtung (16) zur Kühlung des Datenlogger (10), wobei ein Wärmetauscher (12) der Kühleinrichtung (16) an und/oder auf und/oder in dem Datenlogger (10), insbesondere einem Gehäuse desselben, angeordnet ist und/oder wobei die Kühleinrichtung (16) einen Kompressor (13) umfasst, der konfiguriert ist, außen am Fahrzeug befestigt zu werden.

3. System nach Anspruch 1 oder 2, wobei die Steuereinrichtung konfiguriert ist, die Kühlung so durchzuführen, dass die Abwärme des Datenlogger (10) zumindest teilweise, insbesondere zumindest im Wesentlichen vollständig, kompensiert wird.

4. System nach einem der vorhergehenden Ansprüche, wobei der Wärmetauscher (12) unmittelbar auf dem Gehäuse des Datenlogger (10) angeordnet ist.

5. System nach einem der vorhergehenden Ansprüche, wobei die Kühleinrichtung (16) ein Gebläse und/oder einen Fluidkreislauf umfasst.

6. System nach einem der vorhergehenden Ansprüche, wobei der Kompressor (13) konfiguriert ist, auf einer Anhängerkupplung (18) und/oder einem Dachgepäckträger (19) montiert zu werden.

7. System nach einem der vorhergehenden Ansprüche, wobei der Kompressor (13) konfiguriert ist, auf einer glatten Oberfläche montiert zu werden und dazu vorzugsweise mindestens einen Saugnapf aufweist.

8. System nach einem der vorhergehenden Ansprüche, umfassend eine Fluidleitung, die konfiguriert ist, durch den Spalt einer geschlossenen Fahrzeugtür, insbesondere Kofferraumtür, geführt zu werden.

9. System nach einem der vorhergehenden Ansprüche, umfassend das Fahrzeug.

10. Verfahren zum Herrichten eines Fahrzeuges, insbesondere eines Systems nach einem der vorhergehenden Ansprüche, vorzugsweise nach dem unmittelbar vorhergehenden Anspruch, wobei ein Datenlogger (10) zur Erfassung von Daten des Fahrzeuges, sowie eine Kühleinrichtung (16) zur Kühlung des Datenlogger (10), bereitgestellt wird, wobei ein Wärmetauscher (12) der Kühleinrichtung (16) an und/oder auf und/oder in dem Datenlogger (10), insbesondere einem Gehäuse desselben, angeordnet ist oder wird und/oder wobei die Kühleinrichtung (16) einen Kompressor (13) umfasst, der außen am Fahrzeug befestigt wird.

11. Verfahren zum Betreiben eines Datenlogger (10) zur Erfassung von Daten eines Fahrzeuges, insbesondere unter Verwendung des Systems nach einem der vorhergehenden Ansprüche und/oder unter Verwendung eines nach dem Verfahren gemäß dem unmittelbar vorhergehenden Anspruch hergerichteten Fahrzeuges, wobei eine Kühlung, insbesondere des Datenlogger (10) und/oder des Innenraums des Fahrzeugs, in Abhängigkeit von einer durch den Datenlogger (10) emittierten Abwärme durchgeführt wird.

12. Verfahren, umfassend die Verfahren nach den beiden unmittelbar vorhergehenden Ansprüchen.
